(19) Europäisches Patentamt
European Patent Office
Office européen des brevets

(11) **EP 1 941 531 B1**

(12) **EUROPÄISCHE PATENTSCHRIFT**

(45) Veröffentlichungstag und Bekanntmachung des Hinweises auf die Patenterteilung:
**31.12.2008 Patentblatt 2009/01**

(21) Anmeldenummer: **06805391.7**

(22) Anmeldetag: **11.10.2006**

(51) Int Cl.:
***H01J 37/153*** (2006.01)

(86) Internationale Anmeldenummer:
**PCT/DE2006/001773**

(87) Internationale Veröffentlichungsnummer:
**WO 2007/065388 (14.06.2007 Gazette 2007/24)**

(54) **ELEKTRONENOPTISCHER KORREKTOR FÜR APLANATISCHE ABBILDUNGSSYSTEME**

ELECTRON-OPTICAL CORRECTOR FOR AN APLANATIC IMAGING SYSTEM

CORRECTEUR OPTOELECTRONIQUE POUR SYSTEMES DE REPRESENTATION APLANETIQUES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **24.10.2005 DE 102005050810**

(43) Veröffentlichungstag der Anmeldung:
**09.07.2008 Patentblatt 2008/28**

(73) Patentinhaber: **Ceos Corrected Electron Optical Systems GmbH**
**69126 Heidelberg (DE)**

(72) Erfinder: **UHLEMANN, Stephan**
**69115 Heidelberg (DE)**

(74) Vertreter: **Pöhner, Wilfried Anton, Dr.**
**Patentanwalt**
**Postfach 6323**
**97070 Würzburg (DE)**

(56) Entgegenhaltungen:
**WO-A-01/52301          WO-A-99/38188**
**US-A1- 2005 167 607**

• **ROSE H: "Correction of aperture aberrations in magnetic systems with threefold symmetry" NUCLEAR INSTRUMENTS & METHODS IN PHYSICS RESEARCH, NORTH-HOLLAND PUBLISHING COMPANY. AMSTERDAM, NL, Bd. 187, Nr. 1, 1981, Seiten 187-199, XP002090289 ISSN: 0167-5087**

**Beschreibung**

Die Erfindung bezieht sich auf einen elektronenoptischen Korrektor zur Beseitigung sowohl des Öffnungsfehlers dritter Ordnung als auch des anisotropen (azimutalen) Anteils der außeraxialen Koma dritter Ordnung unter Verwendung von Rundlinsen und Hexapolfeldern.

Die Leistungsfähigkeit hochauflösend abbildender elektronenoptischer Systeme, wie z. B. der hochauflösenden Elektronenmikroskopie, wird durch den Öffnungsfehler dritter Ordnung begrenzt. Ein wesentliches Anliegen der Weiterentwicklung derartiger Systeme ist deshalb die Beseitigung des Öffnungsfehlers dritter Ordnung. Ein neben der Hochauflösung weiterhin wichtiges Kriterium der Leistungsfähigkeit ist es, einen Bildbereich hinreichender Größe abbilden zu können. Dessen Grenze wird in hochauflösenden elektronenoptischen Systemen durch den Bildfehler der außeraxialen Koma bestimmt, der sich zusammensetzt aus den Anteilen der radialen Koma, häufig auch als isotrope Koma bezeichnet und der azimutalen Koma, die auch als anisotrope Koma benannt wird. Demnach stehen im einen Begriffsystem radial und azimutal, im anderen Begriffsystem die Bezeichnungen isotrop und anisotrop gegenüber. Gemäß üblicher Terminologie werden elektronenoptische Abbildungssysteme, welche sowohl keinen Öffnungsfehler dritter Ordnung als auch keine außeraxiale Koma aufweisen, als Aplanate bezeichnet. Hiervon abgeleitet werden Systeme als Semi-Aplanate bezeichnet, wenn sie neben der Öffnungsfehlerfreiheit dritter Ordnung lediglich frei von radialer (isotroper) Koma sind. Bei elektronenoptischen Systemen mit gerader Achse und rundem Gauß'schen Strahlengang, die im folgenden stets vorausgesetzt werden, besteht der Öffnungsfehler dritter Ordnung aus der sphärischen Aberration dritter Ordnung. Dabei werden unter Öffnungsfehler all jene Bildfehler zusammengefasst, in deren Fehlerintegralen nur jene Gauß'schen Elementarbahnen eingehen, die von der optischen Achse in der abzubildenden Gegenstandsebene ausgehen. Die Größe des abzubildenden Gegenstands-/Bildfeldes wird hingegen durch die außeraxialen Fehler bestimmt, also jene Fehler, in deren Fehlerintegrale auch Elementarbahnen nach der Gauß'schen Dioptrik enthalten sind, die in der Gegenstandsebene außerhalb der optischen Achse ausgehen. In der hochauflösenden Elektronenoptik steht der Bildfehler der außeraxialen Koma bei der Begrenzung des Bildfeldes im Vordergrund.

Elektronen optische Korrektoren zur Beseitigung von Bildfehlern dritter Ordnung sind aus WO-A-01/52301 bekannt.

In der auf die Anmelderin zurückgehenden Patentanmeldung DE 198 02 409 wird bereits ein Korrektiv beschrieben, bei dem zwei Hexapole Verwendung finden, zwischen denen ein Rundlinsendublett eingebracht ist. Zwischen dem aus diesen Linsen bestehenden Korrektiv und der Objektivlinse wird eine weitere Rundlinse eingebracht in der Weise, dass die komafreie Ebene der Objektivlinse in die komafreie Ebene des Korrektivs abgebildet wird. Der Begriff "komafreie Ebene", oder genauer "komafreie Blendenebene", bezeichnet aber genau genommen die Eigenschaft "frei von isotroper (radialer) Koma". Ein Korrektiv dieses Aufbaues gestattet also die Beseitigung des Öffnungsfehlers dritter Ordnung (Sphärische Aberration 3. Ordnung) der Objektivlinse unter Vermeidung des radialen (isotropen) Anteiles der außeraxialen Koma. Nach der üblichen und oben näher erläuterten Terminologie stellt das System, bestehend aus Objektivlinse, Transfersystem und Korrektiv, im Ergebnis einen Semi-Aplanaten dar.

Bei der beschriebenen Anordnung ist von Nachteil, dass durch die unvermeidliche anisotrope außeraxiale Koma der magnetischen Objektivlinse, die von dem Korrektiv unbeeinflußt gelassen wird, eine Einschränkung des scharf abgebildeten Bildbereiches stattfindet; der durch eine vollständige Beseitigung dieses Bildfehlers eine wesentliche Vergrößerung erfahren könnte.

Hiervon ausgehend hat sich die Erfindung die Schaffung eines elektronenoptischen Korrektivs zur Aufgabe gemacht, welches neben der Beseitigung des Öffnungsfehlers dritter Ordnung auch eine Beseitigung der azimutalen (anisotropen) außeraxialen Koma zum Gegenstand hat.

Gelöst wird diese Aufgabe erfindungsgemäß dadurch, dass der Korrektor aus mindestens drei koaxial angeordneten Hexapolfeldern besteht, wobei zwischen benachbarten Hexapolfeldern mindestens ein Rundlinsenfeld derart angeordnet ist, dass die Hexapolfelder paarweise aufeinander abgebildet werden und die Stärken der Hexapolfelder derart gewählt sind, dass der Bildfehlerkoeffizient des dreizähligen Astigmatismus zu 0 wird und mindestens drei Hexapolfelder im Larmor-Bezugssystem relativ gegeneinander um einen Winkel um die optische Achse verdreht sind.

Die Aufgabe eines Korrektivs besteht darin, die Bildfehler einer Objektivlinse, mit der das Korrektiv zusammenarbeitet, zu eliminieren oder doch zumindest zu verringern. Dabei steht im Rahmen der Erfindung grundsätzlich frei, ob das Korrektiv und das Transferlinsensystem der Linse vor oder nachgeschaltet wird. Im folgenden wird die zu korrigierende Linse, also die Objektivlinse, die in der Regel eine Magnetlinse sein wird, unerwähnt bleiben und primär der Aufbau des Korrektivs beschrieben. Das Korrektiv besteht in seinem prinzipiellen Aufbau aus drei oder mehr Hexapolfeldern und dazwischen stehenden Rundlinsen, die in ihrer Gesamtheit das Korrektiv ergeben. Die Stärken der Hexapolfelder werden derart gewählt, dass der dreizählige Astigmatismus verschwindet.

Aufgrund der vorhandenen axialen Magnetfelder erfolgt eine Drehung der Bahn der Elektronen, im allgemeinen des elektrisch geladenen Partikelstroms. Eine Vereinfachung der Beschreibung der physikalischen Gegebenheiten lässt sich durch die Darstellung in einem Koordinatensystem erreichen, das sich entsprechend der drehenden Bewegung der Elektronen mitbewegt und das als Larmor-Bezugssystem bezeichnet wird. Die im Rahmen dieser Erfindung beschriebene Drehung der Hexapolfelder ist stets relativ zum Larmor-Bezugssystem gemessen.

Die mindestens drei Hexapolfelder sind im Bezug auf die optische Achse relativ gegeneinander so gedreht, dass eine Korrektur der anisotropen außeraxialen Koma stattfindet. In der Praxis wird man einen der Hexapole raumfest halten und die anderen relativ hiergegen soweit verdrehen, bis die Elimination des Bildfehlers der anisotropen außeraxialen Koma erfolgt. Die Vorgehensweise kann entweder durch experimentelles Justieren oder aber auch durch mathematische Ermitteln des Drehwinkels und einer Einstellung demzufolge vorgenommen werden.

Auf diese Weise erhält man ein Korrektiv, das neben dem Öffnungsfehler dritter Ordnung zusätzlich auch die azimutale Komponente der außeraxialen Koma zu eliminieren gestattet. Durch Zusammenschalten mit einer Objektivlinse lässt sich eine Korrektur des gesamten aus Objektivlinse und Korrektor bestehenden Systems erreichen. Durch geeignete Wahl der Längen und Stärken der Hexapolfelder, deren Orientierung sowie die Brennweiten der Rundlinsen lässt sich darüber hinausgehend eine vollständige Elimination aller Fehler zweiter Ordnung, aller axialen Bildfehler vierter Ordnung sowie eine vollständige oder teilweise Symmetriekorrektur der generalisierten Komata vierter Ordnung erzielen.

Grundsätzlich gilt, dass die Bedingung der vollständigen Fehlerkorrektur nicht exakt eingehalten werden muss, da geringfügige Abweichungen von dieser Anordnung das Entstehen weiterer Bildfehler zur Ursache hat, die zum Teil jedoch dazu genutzt werden können, existierende Bildfehler entsprechender Art zu kompensieren. Das an sich nachteilige Entstehen zusätzlicher Bildfehler könnte bei der Möglichkeit der Nutzung zur Kompensation vorhandener Bildfehler als Vorteil betrachtet werden.

Die Zuordnung der Hexapolfelder zu den Rundlinsen hat derart zu erfolgen, dass sie die Hexapolfelder paarweise aufeinander abbilden.

Einer Anordnung, welche diese Bedingung stets erfüllt ist dann gegeben, wenn durch die Rundlinsen eine Abbildung der benachbarten Hexapole aufeinander erfolgt. Eine andere spezielle Lösung wäre, die Rundlinse so einzustellen, dass sie alternierend d. h. jeweils auf den übernächsten Hexapol abbilden.

Bei einfachsymmetrischem Aufbau des Korrektors, bei dem die axiale Fundamentalbahn näherungsweise symmetrisch zur Mittelebene des Korrektors, die außeraxiale Fundamentalbahn aber näherungsweise antisymmetrisch bezüglich der Mittelebene verläuft, läßt sich durch die Einstellung sowohl der Brennweiten der Rundlinse als auch der Längen der Hexapolfelder erreichen, dass neben den vorbeschriebenen Bildfehlern (Öffnungsfehler, außeraxiale Koma) zusätzlich auch der axiale Dreilappfehler und die dreizählige Verzeichnung und teilweise auch Bildfehlerkoeffizienten der generalisierten Komata 4. Seidel'scher Ordnung vermieden werden können.

Bei einem aus drei Hexapolfeldem aufgebauten Korrektiv empfiehlt sich den Drehwinkel der Hexapolfelder äquidistant um die optische Achse zu wählen. Der Winkel des ersten Hexapolfeldes sei $\varphi_1 = \varphi + \Delta$, der des zweiten Hexapolfeldes $\varphi_2 = \varphi$ und der des dritten Hexapolfeldes $\varphi_3 = \varphi - \Delta$, . Die Größe des $\Delta$ ist so zu wählen, dass die anisotrope (azimutale) Koma kompensiert wird. Wird der Wert $\Delta$ hingegen 0, so dass die Achsen aller drei Hexapole zusammenfallen, erfolgt keine Korrektur der anisotropen Koma sondern lediglich die des Öffnungsfehlers 3. Ordnung.

Eine besonders vorteilhafte Weiterbildung besteht in der Verwendung von fünf Korrekturstücken, bei denen die Hexapolfelder im Hinblick auf ihren Drehwinkel um die optische Achse in der Weise orientiert sind, dass $\varphi_1 = \varphi$, $\varphi_2 = \varphi \pm 30°$, $\varphi_3 = \varphi + 60°$, $\varphi_4 = \varphi \pm -30°$ und $\varphi_5 = \varphi$ ist. Hierbei wird die Vorzeichenwahl nur durch die Drehrichtung der Frontlinse bestimmt. Die Eliminierung der anisotropen (azimutalen) Koma der magnetischen Frontlinse lässt sich über die Stärke der Hexapolfelder des zweiten und vierten Korrekturstückes getrennt einstellen.

In einer Weiterbildung mit einer größeren Anzahl von Korrekturstücken empfiehlt es sich, hierbei den Korrektor doppelsymmetrisch aufzubauen, so dass auch ein doppelsymmetrischer Strahlengang derart erzeugt wird, dass die axiale Fundamentalbahn zur Mittelebene des Korrektors antisymmetrisch, jedoch symmetrisch bezüglich der Mittelebenen der ersten und zweiten Hälfte des Korrektors verläuft. Die außeraxialen Fundamentalbahnen verlaufen symmetrisch bezüglich der Mittelebene des Korrektors und antisymmetrisch bezüglich der Mittelebenen der ersten und zweiten Hälften des Korrektors. Die Amplituden der Hexapolfelder sind hierbei symmetrisch bezüglich aller drei Ebenen zu wählen.

Bei einem System bestehend aus sechs Hexapolfeldern erfolgt die Korrektur der anisotropen Koma entweder über die Einstellung der Stärke des zweiten und vorletzten Hexapolfeldes, wenn die Drehwinkel wie folgt betragen:

$$\varphi_1 = \varphi \,, \; \varphi_2 = \varphi \pm 30° \,, \; \varphi_3 = \varphi + 60° \,, \; \varphi_4 = \varphi \; \text{und} \; \varphi_5 = \varphi \pm 30° \; \text{und} \; \varphi_1 = \varphi + 60°.$$

Bei einer Anordnung aus sechs Korrekturstücken ist die Kompensation der anisotropen, auch durch die Wahl der Winkeldifferenz möglich, wenn die Drehung der einzelnen Korrekturstücke wie folgt gewählt wird:

$$\varphi_1 = \varphi + \Delta, \ \varphi_2 = \varphi, \ \varphi_3 = \varphi - \Delta, \ \varphi_4 = \varphi + \Delta, \ \varphi_5 = \varphi \ \text{ und } \ \varphi_6 = \varphi - \Delta$$

Beim doppelsymmetrischen Aufbau des Korrektors können Brennweiten und Längen der Hexapolfelder frei gewählt werden, da der axiale Dreilappfehler, die dreizählige Verzeichnung und die generalisierten Komata 4. Seidel'scher Ordnung durch Symmetriekorrektur verschwinden.

Die Erzeugung des Hexapolfeldes steht im Rahmen der Erfindung grundsätzlich frei. Das Hexapolfeld entsteht nach Verwendung eines Multipolelementes mit 6-zähliger Drehsymmetrie. Auch ist es möglich ein Multipolelement mit 12-zähliger Drehsymmetrie zu verwenden und durch gleichsinnige Beaufschlagung benachbarte Polelemente ein Hexapolfeld zu erhalten. Durch nachträgliche Veränderung der Beaufschlagung eines einzelnen Polelementes lässt sich unter Beibehaltung der mechanischen Positionierung einer Drehung und Einstellung des elektrischen und/oder magnetischen Hexapolfeldes erreichen.

In einer Ausführungsform schließlich wird eine Rundlinse aus zwei oder mehr magnetischen Linsenfeldern zusammengesetzt, sodass zur Einstellung und Justierung die jeweiligen Stärken als Parameter zur Verfügung stehen. Eine derartige Anordnung erzeugt ein Rundlinsenfeld, daß es bei entsprechender Wahl der jeweiligen Stärke möglich macht, unter Beibehaltung der Brechkraft der Rundlinse die Larmor-Drehung des Feldes in der gewünschten Weise einzustellen. Die beiden Freiheitsgrade der Einstellung der Stärken der beiden magnetischen Linsen, beinhaltet die Möglichkeit der Einstellung von Brechkraft und Larmor-Drehung der gesamten Rundlinse unabhängig voneinander.

Die Anordnung des vorbeschriebenen Korrektivs hat zum Ergebnis, dass neben der Beseitigung des Öffnungsfehlers dritter Ordnung auch die anisotrope (azimutale) außeraxiale Koma dritter Seidel'scher Ordnung beseitigt werden kann. In der Praxis liefert die magnetische Objektivlinse den dominanten Beitrag zur außeraxialen Koma. Durch Abbildung der komafreien Ebene der Objektivlinse in das erste Hexapolfeld des Korrektors müssen bei Verwendung des vorbeschriebenen Korrektivs häufig keine zusätzlichen Anstrengungen unternommen werden, um die isotrope (radiale) Koma zu beseitigen, da das Hexapolfeld bzw. deren Mittelebene nahe an der komafreien Ebene liegen und folglich die isotrope (radiale) Koma gering ist.

Für das Transferlinsensystem zwischen Korrektor und Objektiv bestehen zwei Alternativen:
Das Transferlinsensystem kann aus einer einzigen Rundlinse bestehen, die im Hinblick auf ihre Stärke und Position so einzustellen ist, dass die komafreie Ebene der Objektivlinse in die komafreie Ebene des Korrektivs abgebildet wird.

Die Alternative besteht in der Verwendung eines Rundlinsendubletts als Transferlinsensystem zwischen Objektivlinse und Korrektor. Auch hier folgt die Einstellung in der Weise, dass die komafreie Ebene der Objektivlinse in die komafreie Ebene des Korrektivs abgebildet wird.

Diese Maßnahmen sorgen dafür, dass zusätzlich zu den oben beschriebenen Bildfehlern die isotrope (radiale) Koma vermieden werden kann. Man erhält dann eine Anordnung, welche die Eigenschaften eines Aplanaten besitzt.

Für die Möglichkeit der Korrektur ist es unerheblich, ob der Korrektor in Richtung des Strahlenganges und ggf. unter Zwischenschalten von Transferlinsen hinter der zu korrigierenden Linse angeordnet ist oder ob Korrektor und ggf. Transferlinsen vor der zur korrigierenden Linse angeordnet sind. Ziel ist immer durch Einstellung des Korrektors bzw. der Transferlinsen eine vollständige Elimination bestimmter Bildfehler des gesamten optischen Systems zu erreichen.

Weitere Einzelheiten, Merkmale und Vorteile der Erfindung lassen sich dem nachfolgenden Beschreibungsteil entnehmen, in dem anhand der Zeichnung Ausführungsbeispiele der Erfindung näher erläutert werden. Es zeigen:

Figur 1: Korrektor mit drei Korrekturstücken
Figur 2: Korrektor mit ebenfalls drei Korrekturstücken
Figur 3: Korrektor mit fünf Korrekturstücken
Figur 4: Korrektor mit sechs Korrekturstücken

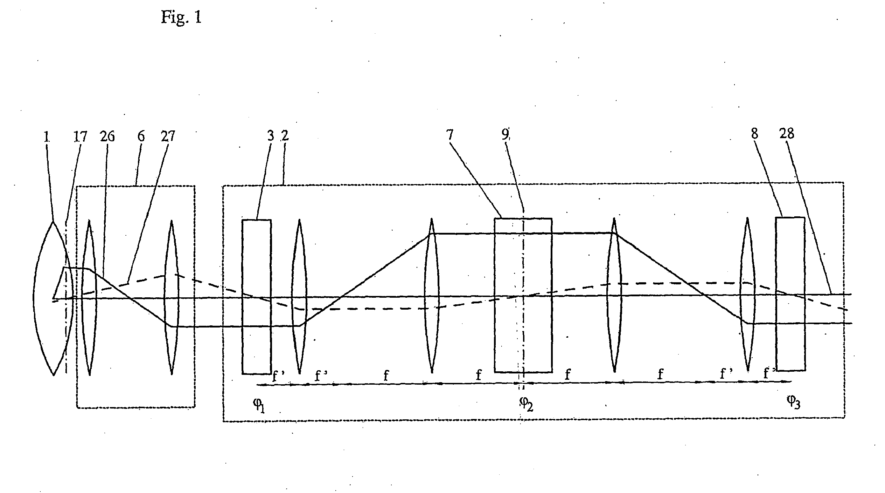

Figur 1 zeigt in prinzipienhaft gehaltener Seitenansicht den Aufbau einer elektronoptischen Anordnung bestehend aus einer Objektivlinse 1, die in der Regel eine magnetische Rundlinse ist, einem Korrektor 2 und einem dazwischen angeordnetem Transferlinsensystem 6. Alle diese einzelnen Elemente haben die optische Achse 28 gemeinsam.

Der Korrektor 2 enthält insgesamt 3 Hexapolfelder (3, 7 und 8) und dazwischen geschaltete Rundlinsen, die hintereinander angeordnet sind und in die ihrer Gesamtheit den Korrektor 2 ergeben. In Richtung des Strahlenganges steht ein erstes Hexapolfeld 3, dargestellt als Rechteck, eine erste Rundlinse mit der Brennweite f

Der Abstand zwischen Rundlinse und Mittelebene entspricht der Brennweite f'. Der Drehwinkel indem das Hexapolfeld um die optische Achse ausgerichtet ist sei $\varphi_1$.

Hieran schließen sich ein weiteres Hexapolfeld (7) und zwei Rundlinsen an, deren Brennweite f den Abstand zur Symmetrieebene (9) des Korrektivs definiert.

In Fortsetzung des Strahlenganges folgt eine Rundlinse und das dritte und damit letzte Hexapolfeld (8), welches spiegelsymmetrisch zum ersten aufgebaut ist.

Die gesamte Anordnung ist spiegelsymmetrisch zur Mittelebene 9. Der Winkel des Hexapolfeldes 7 beträgt $\varphi_2$, der des Hexapolfeldes 8 $\varphi_3$. Im Ergebnis sind somit alle drei Hexapolfelder in verschiedenen Winkeln um die optische Achse gedreht. Die Einstellung der Drehwinkel und die Hexapolfeldstärken sind so zu wählen, dass neben dem Öffnungsfehler dritter Ordnung auch die anisotrope (azimutale) außeraxiale Koma dritter Ordnung beseitigt wird. Letztlich hat die Einstellung so zu erfolgen, dass die Bildfehler des gesamten Systems, also die durch die Objektivlinse 1 generierten Bildfehler kompensiert sind.

Zwischen der Objektivlinse 1 und dem Korrektor 2 ist ein aus zwei Rundlinsen bestehendes Transferlinsensystem 6 zwischengeschaltet. Dessen Einstellung erfolgt in der Weise, dass die Komafreie Ebene 17 der Objektivlinse 1 in die komafreie Ebene des Korrektors 2 abgebildet wird. Die axiale Fundamentalbahn 26 hat den in der Abbildung wiedergebenden Verlauf. Durch entsprechenden Einstellung des Transferlinsensystems 6 erhält man in der Gesamtheit mit Korrektor 2 ein Korrektursystem, das in der Lage ist, sowohl den Öffnungsfehler 3. Ordnung als auch die außeraxiale Koma, und zwar sowohl deren isotropen (radialen) als auch anisotropen (azimutalen) Anteil zu eliminieren.

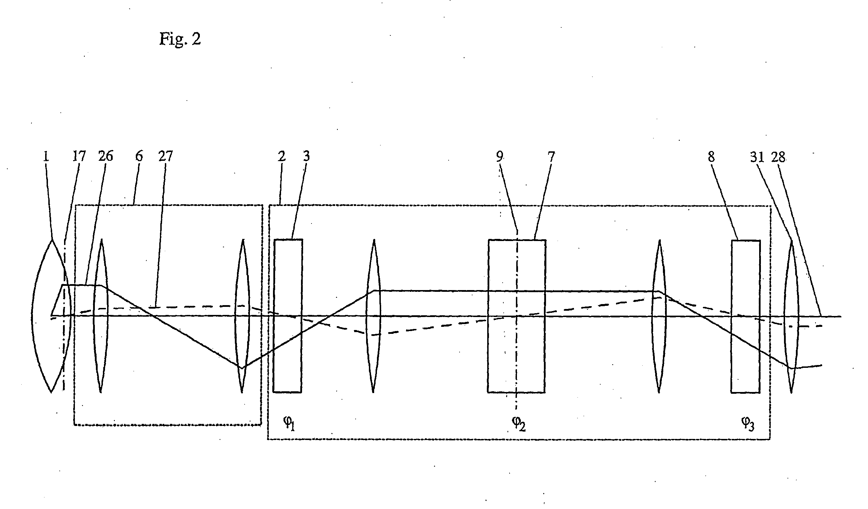

Einen hierzu abweichenden Aufbau zeigt Figur 2. Hierbei ist zwischen den Hexapolen jeweils nur eine Rundlinse angeordnet. Ebenso wie in Figur 1 erfolgt die Einstellung und räumliche Anordnung von Hexapolfeldern und Rundlinsen in der Weise, dass die Hexapole aufeinander abgebildet werden. Hinter dem Korrektor ist beispielhaft eine typischerweise verwendete Adapterlinse (31) angeordnet, die einen parallelen oder konvergenten axialen Strahlengang hinter dem Korrektiv einstellt.

Zwischen Objektivlinse 1 und Korrektor 2 findet sich ebenfalls ein Transferlinsensystem 6, welches aus zwei Rundlinsen besteht. Auch hier erfolgt Anordnung und Einstellung der Transferlinsensystems 6 in der Weise, dass die komafreie Ebene 17 der Objektivlinse 1 in die komafreie Ebene des Korrektors (2) abgebildet wird. Hierdurch erfolgt sowohl eine Kompensation des isotropen Anteils der außeraxialen Koma neben der des Öffnungsfehlers 3. Ordnung als auch der des anisotropen (azimutalen) Anteils der außeraxialen Koma.

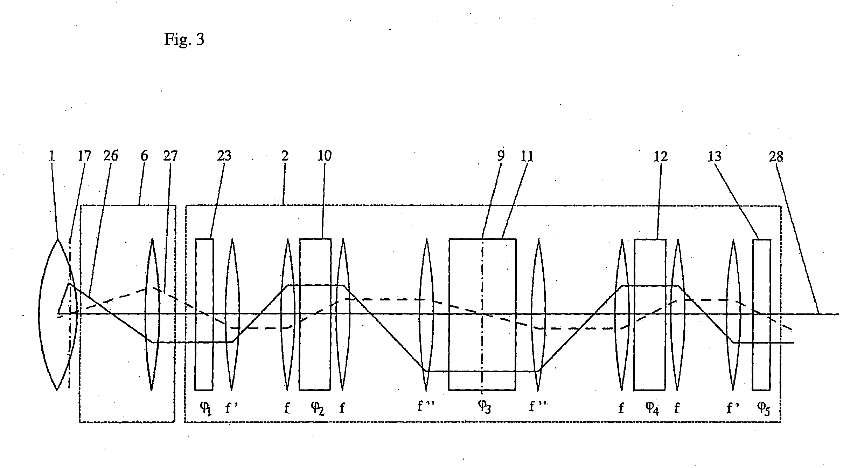

Der in Figur 3 gezeigte Korrektor 2 besteht aus insgesamt 5 Hexapolfeldern 23, 10, 11, 12, 13 und jeweils 2 zwischengeschalteten Rundlinsen. Der gesamte Aufbau des Korrektors 2 ist im Hinblick auf Amplituden der Hexapolfelder und der Brennweiten der Rundlinsenfelder symmetrisch zur Mittelebene 9. Die Drehwinkel der Hexapolfelder sind mit $\varphi_1$, $\varphi_2$, $\varphi_3$, $\varphi_4$, und $\varphi_5$ bezeichnet.

Zwischen der Objektivlinse 1 und Korrektor 2 ist ein aus einer Rundlinse bestehendes Transferlinsensystem 6 angeordnet.

Der Vorteil dieser Anordnung besteht darin, dass bei vorgegebener Orientierung der Hexapole im Winkel $\varphi_i$ die Einstellung der Korrektur der anisotropen Koma über die Stärke der Hexapole 10 und 12 erfolgen kann. Eine Änderung des Drehwinkels $\varphi_i$, der einzelnen Korrekturstücke ist zur Einstellung der Kompensation also nicht erforderlich.

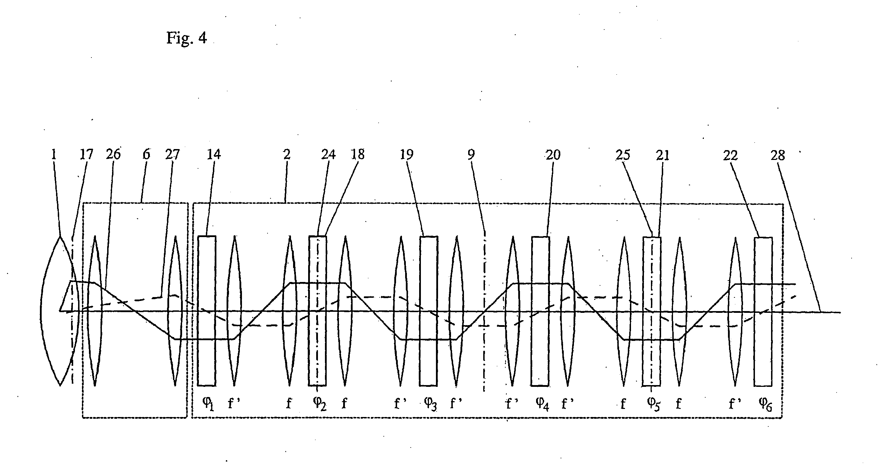

In Figur 4 schließlich wird ein Korrektor 2 gezeigt, der aus Hexapolfeldern (14,18,19,20,21,22) und Rundlinsen doppelsymmetrisch aufgebaut ist. Demzufolge wird auch ein doppelsymmetrischer Strahlengang erzeugt, bei dem die axiale Fundamentalbahn 26 zur Mittelebene 9 des Korrektors 2 antisymmetrisch und symmetrisch bezüglich den Mittelebenen 24 und 25 der ersten und zweiten Hälfte des Korrektors verlaufen. Die außeraxiale Fundamentalbahn 27 verläuft hingegen symmetrisch bezüglich dieser Mittelebene 9 und antisymmetrisch bezüglich der Ebenen 24 und 25. Die Amplituden der Hexapolfelder sind hierbei symmetrisch, sowohl zur Mittelebene 9 als auch zu den Ebenen 24, 25. Die Kompensation des Bildfehlers der anisotropen außenaxialen Koma kann bei konstanter Winkeleinstellung $\varphi_i$ durch entsprechende Wahl der Amplituden der Hexapolfelder 18, 21, also jenen, die in den Ebenen 24, 25 liegen, erfolgen oder aber bei konstanten Polstärken durch entsprechende Wahl des Drehwinkels der einzelnen Korrekturstücke in ihrem Winkel $\varphi_i$.

**Patentansprüche**

1. Elektronenoptischer Korrektor zur Beseitigung sowohl des Öffnungsfehlers dritter Ordnung als auch des anisotropen (azimutalen) Anteils der außeraxialen Koma dritter Ordnung unter Verwendung von Rundlinsen und Hexapolfeldern, wobei der Korrektor aus mindestens drei koaxial angeordneten Hexapolfeldern (3, 7, 8, 10 -14, 18 - 23) besteht, wobei zwischen benachbarten Hexapolfeldern mindestens ein Rundlinsenfeld derart angeordnet ist, dass die Hexapolfelder paarweise aufeinander abgebildet werden und die Stärken der Hexapolfelder derart gewählt sind, dass der Bildfehlerkoeffizient des dreizähligen Astigmatismus zu 0 wird und mindestens drei Hexapolfelder im Larmor-Bezugssystem relativ gegeneinander um einen Winkel um die optische Achse verdreht sind.

2. Korrektor nach Anspruch 1, **dadurch gekennzeichnet, dass** die Rundlinsen so eingestellt sind, dass sie die benachbarten Hexapolfelder aufeinander abbilden.

3. Korrektor nach Anspruch 1, **dadurch gekennzeichnet, dass** die Rundlinsen so eingestellt sind, dass sie die Hexapolfelder alternierend aufeinander abbilden.

4. Korrektor nach einem der vorhergehenden Ansprüche, **dadurch gekennzeichnet, dass** der Korrektor (2) symmetrisch aufgebaut ist und dass die axiale Fundamentalbahn (26) symmetrisch zur Mittelebene (9) des Korrektors (2) und die außeraxiale Fundamentalbahn (27) antisymmetrisch zur Mittelebene (9) verläuft.

5. Korrektor nach Anspruch 4, **dadurch gekennzeichnet, dass** der Korrektor (2) drei Hexapolfelder (3, 7, 8) enthält, die in Bezug auf ihren Drehwinkel im Larmor-Bezugssystem äquidistant angeordnet sind.

6. Korrektor nach Anspruch 4, **dadurch gekennzeichnet, dass** der Korrektor (2) aus fünf Hexapolfeldern (23,10,11, 12, 13) besteht und die Orientierungen der Hexapolfelder im Bezug auf ihren Drehwinkel im Larmor-Bezugssystem $\varphi_1 = \varphi$, $\varphi_2 = \varphi \mp 30°$, $\varphi_3 = \varphi+60°$, $\varphi4 = \varphi \pm 30°$, und $\varphi_5 = \varphi$ betragen.

7. Korrektor nach einem der Ansprüche 1 - 3, **dadurch gekennzeichnet, dass** der Korrektor (2) doppelsymmetrisch aufgebaut ist und dass die axiale Fundamentalbahn antisymmetrisch zur Mittelebene (9) und symmetrisch zu den Mittelebenen (24 und 25) der ersten und zweiten Hälfte des Korrektors (2) verläuft und die außeraxiale Fundamentalbahn (27) symmetrisch zur Mittelebene (9) und antisymmetrisch zu den Mittelebenen (24 und 25) verläuft.

8. Korrektor nach Anspruch 7, **dadurch gekennzeichnet, dass** der Korrektor (2) aus sechs Hexapolfeldern (14, 18 - 22) besteht und die Winkel der Hexapolfelder im Larmor-Bezugssystem $\varphi_1 = \varphi$, $\varphi_2 = \varphi \pm 30°$, $\varphi_3 = \varphi + 60°$, $\varphi_4 = \varphi$, $\varphi_5 = \varphi \pm 30°$ und $\varphi_6 = \varphi + 60°$ betragen.

9. Korrektor nach Anspruch 7, **dadurch gekennzeichnet, dass** der Korrektor aus sechs Hexapolfeldern (14, 18 - 22) besteht, die Orientierung der Felder im Larmor-Bezugssystem $\varphi_1 = \varphi + \Delta\varphi$, $\varphi_2 = \varphi$, $\varphi_3 = \varphi - \Delta\varphi$, $\varphi_4 = \varphi + \Delta\varphi$, $\varphi_5 = \varphi$, und $\varphi_6 = \varphi - \Delta\varphi$, betragen und der Wert $\Delta\varphi$ einstellbar ist.

10. Korrektor nach einem der vorhergehenden Ansprüche, **dadurch gekennzeichnet, dass** ein Hexapolfeld von einem Multipolelement mit 6-zähliger Drehsymmetrie erzeugt wird.

11. Korrektor nach einem der vorhergehenden Ansprüche, **dadurch gekennzeichnet, dass** ein Hexapolfeld (3, 7, 8,10-14,18 23) von einem Multipolelement mit 12-zähliger Drehsymmetrie erzeugt wird.

12. Korrektor nach einem der vorhergehenden Ansprüche, **dadurch gekennzeichnet, dass** eine Rundlinse aus mindestens zwei magnetischen Linsen zusammengesetzt ist, die in ihrer jeweiligen Stärke individuelle derart einstellbar sind, dass unter Beibehaltung der Brechkraft der Rundlinse deren Larmordrehung einstellbar ist.

13. Korrektor nach einem der vorhergehenden Ansprüche, **dadurch gekennzeichnet, dass** auf die Objektivlinse (1) derart eingestellt ist, dass sie die komafrei Ebene (17) der Objektivlinse (1) in die Ebene des ersten Hexapols abbildet.

14. Korrektor nach einem der vorhergehenden Ansprüche, **dadurch gekennzeichnet, dass** in Richtung auf die Objektivlinse (1) ein Transferlinsensystem (6) dem Korrektor (2) vorgeschaltet ist, welches aus einer Rundlinse oder aus einem Rundlinsendublett besteht, welches die komafreie Ebene (17) des Objektivs (1) in die komafreie Ebene des Korrektivs abbildet.

15. Korrektor nach einem der vorhergehenden Ansprüche, **dadurch gekennzeichnet, dass** dem Korrektor (2) eine Objektivlinse (1) und ein Transferlinsensystem (6) in Richtung des Strahlenganges vor- oder nachgeschaltet sind.

**Claims**

1. Electron-optical corrector for eliminating both third-order spherical aberration and the anisotropic (azimuthal) component of the third-order extra-axial coma using circular lenses and hexapole fields, the corrector consisting of at least three coaxially arranged hexapole fields (3, 7, 8, 10-14, 18-23), at least one circular lens field being arranged between adjacent hexapole fields such that the hexapole fields are imaged on one another in pairs and the intensities of the hexapole fields are chosen such that the image aberration coefficient of the astigmatism with threefold symmetry becomes 0 and
at least three hexapole fields in the Larmor reference system being rotated relative to one another by an angle about the optical axis.

**2.** Corrector according to claim 1, **characterised in that** the circular lenses are adjusted such that they image the adjacent hexapole fields on one another.

**3.** Corrector according to claim 1, **characterised in that** the circular lenses are adjusted such that they alternately image the hexapole fields on one another.

**4.** Corrector according to one of the preceding claims, **characterised in that** the corrector (2) is symmetrically constructed and **in that** the axial fundamental path (26) is symmetrical to the centre plane (9) of the corrector (2), and the extra-axial fundamental path (27) is antisymmetrical to the centre plane (9)

**5.** Corrector according to claim 4, **characterised in that** the corrector (2) contains three hexapole fields (3, 7, 8), which are arranged equidistantly with respect to their angle of rotation in the Larmor reference system.

**6.** Corrector according to claim 4, **characterised in that** the corrector (2) consists of five hexapole fields (23,10,11, 12,13), and the orientations of the hexapole fields with respect to their angle of rotation in the Larmor reference systems are $\varphi_1 = \varphi$, $\varphi_2 = \varphi \pm 30°$, $\varphi_3 = \varphi + 60°$, $\varphi_4 = \varphi \pm 30°$, and $\varphi_5 = \varphi$ betragen.

**7.** Corrector according to one of claims 1-3, **characterised in that** the corrector (2) is doubly symmetrically constructed and **in that** the axial fundamental path is antisymmetrical to the centre plane (9) and symmetrical to the centre planes (24 and 25) of the first and second half of the corrector (2), and the extra-axial fundamental path (27) is symmetrical to the centre plane (9) and antisymmetrical to the centre planes (24 and 25).

**8.** Corrector according to claim 7, **characterised in that** the corrector (2) consists of six hexapole fields (14,18-22), and the angles of the hexapole fields in the Larmor reference systems are $\varphi_1 = \varphi$, $\varphi_2 = \varphi \pm 30°$, $\varphi_3 = \varphi + 60°$, $\varphi_4 = \varphi$, $\varphi_5 = \varphi \pm 30°$ and $\varphi_6 = \varphi + 60°$.

**9.** Corrector according to claim 7, **characterised in that** the corrector (2) consists of six hexapole fields (14,18-22), and the orientations of the fields in the Larmor reference systems are $\varphi_1 = \varphi + \Delta\varphi$, $\varphi_2 = \varphi$, $\varphi_3 = \varphi - \Delta\varphi$, $\varphi_4 = \varphi + \Delta\varphi$, $\varphi_5 = \varphi$, $\varphi_6 = \varphi - \Delta\varphi$, and the value $\Delta\varphi$ is adjustable.

**10.** Corrector according to one of the preceding claims, **characterised in that** a hexapole field is generated by a multipole element with six-fold rotational symmetry.

**11.** Corrector according to one of the preceding claims, **characterised in that** a hexapole field (3, 7, 8, 10-14, 18-23) is generated by a multipole element with 12-fold rotational symmetry.

**12.** Corrector according to one of the preceding claims, **characterised in that** a circular lens is composed of at least two magnetic lenses, which are adjustable as regards their respective intensities such that their Larmor rotation is adjustable while maintaining the refractive power of the circular lens.

**13.** Corrector according to one of the preceding claims, **characterised in that** the objective lens (1) is adjusted in such a way that it images the coma-free plane (17) of the objective lens (1) in the plane of the first hexapole.

**14.** Corrector according to one of the preceding claims, **characterised in that**, in the direction of the objective lens (1), the corrector (2) is preceded by a transfer lens system (6), which consists of a circular lens or a circular-lens doublet, which images the coma-free plane (17) of the objective (1) in the coma-free plane of the corrective.

**15.** Corrector according to one of the preceding claims, **characterised in that** an objective lens (1) and a transfer lens system (6) are connected in front of or behind the corrector (2) in the direction of the ray path.

**Revendications**

**1.** Correcteur optique électronique destiné à éliminer, tant l'erreur d'ouverture de troisième ordre que la part anisotrope (azimutale) du coma extra-axial de troisième ordre en utilisant des lentilles rondes et des champs d'hexapôle, sachant que ce correcteur est constitué d'au moins trois champs d'hexapôle (3, 7, 8, 10 -14,18 - 23) disposés de façon coaxiale, sachant qu'au moins un champ de lentilles rondes est disposé entre les champs d'hexapôle voisins de façon à ce que les champs d'hexapôle soient reproduits par paire lés uns sur les autres et que les puissances des champs sont choisies de façon à ce que le coefficient d'erreur d'image de l'astigmatisme à trois chiffres devienne 0 et qu'au moins trois champs d'hexapôle dans le système de référence de Larmor sont tournés d'un angle autour de l'axe optique.

2.  Correcteur selon la revendication 1 **caractérisé par le fait que** les lentilles rondes sont réglées de façon à ce que les champs d'hexapôle voisins soient représentés les uns sur les autres.

3.  Correcteur selon la revendication 1 **caractérisé par le fait que** les lentilles rondes sont réglées de façon à ce que les champs d'hexapôle voisins soient représentés les uns sur les autres de façon alternée.

4.  Correcteur selon la revendication 1 **caractérisé par le fait que** le correcteur (2) a une construction symétrique, que la voie fondamentale (26) suit un tracé symétrique par rapport au plan médian (9) du correcteur (2), et que la voie fondamentale extra-axiale (27) suit un tracé antisymétrique par rapport au plan médian (9).

5.  Correcteur selon la revendication 4 **caractérisé par le fait que** le correcteur (2) contient trois champs d'hexapôle (3, 7, 8), qui sont disposés de façon équidistante sur leur angle de rotation dans le système de référence de Larmor.

6.  Correcteur selon la revendication 4 **caractérisé par le fait que** le correcteur (2) est constitué de cinq champs d'hexapôle (23, 10, 11, 12, 13) et que les orientations des champs d'hexapôle est, par rapport à leur angle de rotation dans le système de référence de Larmor, $\varphi_1 = \varphi$, $\varphi_2 = \varphi \mp 30°$, $\varphi_3 = \varphi + 60°$, $\varphi_4 = \varphi \pm 30°$, et $\varphi_5 = \varphi$.

7.  Correcteur selon une des revendications 1 - 3, **caractérisé par le fait que** le correcteur (2) a une construction doublement symétrique et que la voie axiale fondamentale suit un tracé antisymétrique par rapport au plan médian (9) et symétrique par rapport aux plans médian (24 et 25) de la première et la seconde moitié du correcteur (2), et que la voie fondamentale extra-axiale (27) suit un tracé symétrique par rapport au plan médian (9) et antisymétrique par rapport aux plans médians (24 et 25).

8.  Correcteur selon la revendication 7, **caractérisé par le fait que** le correcteur (2) est constitué de six champs d'hexapôle (14, 18 et 22), et que l'angle des champs d'hexapôle dans le système de référence de Larmor est $\varphi_1 = \varphi$, $\varphi_2 = \varphi \pm 30°$, $\varphi_3 = \varphi + 60°$, $\varphi_4 = \varphi$, $\varphi_5 = \varphi \pm 30°$, et $\varphi_6 = \varphi + 60°$.

9.  Correcteur selon la revendication 7, **caractérisé par le fait que** le correcteur est constitué de six champs d'hexapôle (14, 18 et 22), l'orientation des champs dans le système de référence de Larmor étant $\varphi_1 = \varphi + \Delta\varphi$, $\varphi_2 = \varphi$, $\varphi_3 = \varphi - \Delta\varphi_1$, $\varphi_4 = \varphi + \Delta\varphi$, $\varphi_5 = \varphi$, et $\varphi_6 = \varphi - \Delta\varphi$, et la valeur $\Delta\varphi$ pouvant être réglée.

10. Correcteur selon une des revendications précédentes, **caractérisé par le fait qu'**un champ d'hexapôle est créé par un élément multipôles ayant une symétrique de rotation à 6 chiffres.

11. Correcteur selon une des revendications précédentes, **caractérisé par le fait qu'**un champ d'hexapôle (3, 7, 7, 8, 10 -14, 18 - 23) est créé par un élément multipôles ayant une symétrique de rotation à 12 chiffres.

12. Correcteur selon une des revendications précédentes, **caractérisé par le fait qu'**une lentille ronde est constituée d'au moins deux lentilles magnétiques dont les puissances respectives peuvent être réglées individuellement de façon à ce que la rotation de Larmor des lentilles puisse être réglée en conservant leur vergence.

13. Correcteur selon une des revendications précédentes, **caractérisé par le fait que** la lentille de l'objectif (1) est réglée de façon à reproduire le niveau sans coma (17) de la lentille de l'objectif (1) dans le niveau du premier hexapôle.

14. Correcteur selon une des revendications précédentes, **caractérisé par le fait qu'**un système de lentilles de transfert (6) est branché en amont du correcteur (2) en direction de la lentille de l'objectif, lequel est constitué d'une lentille ronde ou d'un doublet de lentilles rondes, qui reproduit le plan sans coma (17) de l'objectif (1) dans le plan sans coma du correctif.

15. Correcteur selon une des revendications précédentes, **caractérisé par le fait qu'**une lentille d'objectif (1) et un système de transfert (6) sont branchés en amont ou en aval du correcteur (2) en direction du parcours du rayon.

Fig. 1

EP 1 941 531 B1

Fig. 2

EP 1 941 531 B1

Fig. 3

Fig. 4

**IN DER BESCHREIBUNG AUFGEFÜHRTE DOKUMENTE**

**In der Beschreibung aufgeführte Patentdokumente**

- WO 0152301 A
- DE 19802409